Europäisches Patentamt

(19) European Patent Office

Office européen des brevets

(11) Publication number: **0 052 465**
**B1**

(12) **EUROPEAN PATENT SPECIFICATION**

(45) Date of publication of patent specification: **26.03.86**

(21) Application number: **81305250.3**

(22) Date of filing: **04.11.81**

(51) Int. Cl.⁴: **H 01 L 27/02,** H 03 K 19/091,
H 01 L 21/82

(54) **I2L semiconductor device.**

(30) Priority: **13.11.80 JP 159930/80**

(43) Date of publication of application:
**26.05.82 Bulletin 82/21**

(45) Publication of the grant of the patent:
**26.03.86 Bulletin 86/13**

(84) Designated Contracting States:
**DE FR GB**

(56) References cited:

**PATENTS ABSTRACTS OF JAPAN, vol. 2, no.
97, page 4716 E 78;**

**ELECTRONICS, vol. 52, no. 25, 6th December
1979, pages 124-130, New York (USA); J.G.
POSA et al.: "IEDM unveils new highs in speed,
power, density"**

(73) Proprietor: **Kabushiki Kaisha Toshiba
72, Horikawa-cho Saiwai-ku
Kawasaki-shi Kanagawa-ken 210 (JP)**

(72) Inventor: **Ikeda, Masashi
2-601 3-3-2, Tsuji
Urawa-shi Saitama-ken (JP)**

(74) Representative: **Freed, Arthur Woolf et al
MARKS & CLERK 57-60 Lincoln's Inn Fields
London WC2A 3LS (GB)**

Courier Press, Leamington Spa, England.

## Description

This invention relates to integrated injection logic ($I^2L$) semiconductor devices.

The $I^2L$ circuit is a bipolar digital circuit realized by a semiconductor device of high integration density and low consumption power. The $I^2L$ semiconductor device has an advantage that a linear circuit section can be integrated together with an $I^2L$ circuit section on the same chip. For this reason, various $I^2L$ semiconductor circuits are extensively used for home and industrial large scale integrated circuits (LSI) for which both the linear and digital functions are required. Recently, the application field of the LSI has been further extended, and there are demands for the $I^2L$ digital circuit section to operate at higher speeds and for the linear circuit section to operate at higher voltages.

Basically, the $I^2L$ circuit operates at a low voltage (about 0.7 V) and requires a thin epitaxial layer section in the substrate of a semiconductor device which constitutes this circuit. However, the emitter-collector breakdown voltage of an npn transistor in the linear circuit section that is formed together with the $I^2L$ circuit section using the substrate having a thin epitaxial layer, is about 10 V. Therefore, it is impossible to obtain as high breakdown voltage as 30 to 50 V required for usual purposes. A bipolar integrated circuit that satisfies the required characteristics of both the $I^2L$ circuit section and linear circuit section is therefore complicated in manufacture and high in manufacturing cost.

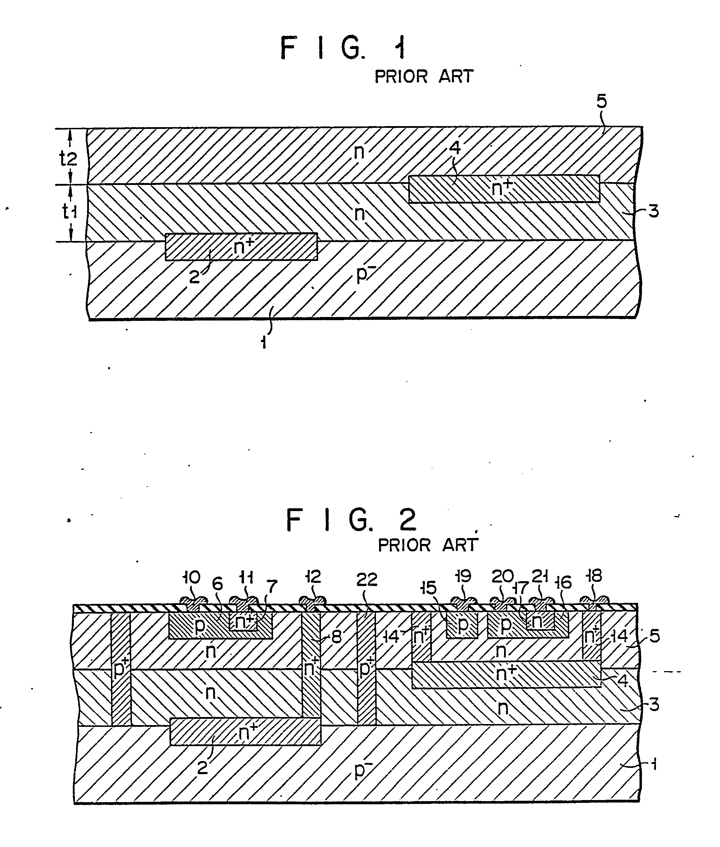

For example, when manufacturing a semiconductor device including a high breakdown voltage linear circuit section and a high speed $I^2L$ circuit section formed on the same chip as shown in Fig. 2, an epitaxial wafer as shown in Fig. 1 is used. This epitaxial wafer is formed by diffusing n-type impurities at a high impurity concentration into the surface region of a p⁻-type substrate 1 to form a buried layer 2, epitaxially growing n-type semiconductor layer 3 to a thickness t1 on the substrate 1 and the buried layer 2, forming an n⁺-type buried layer 4 in the surface region of the epitaxial layer 3 not overlapping the buried layer 2, and forming an n-type semiconductor layer 5 to a thickness t2 on the epitaxial layer 3 and the buried layer 4.

The circuit construction as shown in Fig. 2 may be fabricated using the semiconductor wafer of Fig. 1. A vertical npn transistor TR1 constituting the linear section circuit is formed in a region including the buried layer 2, and lateral npn transistor TR2 and vertical npn transitor TR3 constituting the $I^2L$ circuit section are formed in a region containing the buried layer 4. A p-type region 6 is formed in the surface region of the epitaxial layer 5, an n⁺-type region 7 is formed in the P-type region 6, and an n-type diffusion region 8 is formed to extend from the surface of the epitaxial layer 5 to be buried layer 2. Electrodes 10, 11 and 12 are formed in connection with the respective regions 6, 7 and 8.

An n⁺-type diffusion region 14 is formed by diffusion to extend from the surface of the epitaxial layer 5 to the n⁺-type region 4. P-type regions 15 and 16 are formed in the surface regions of the epitaxial layer 5 enclosed by the diffusion region 14. These regions 15 and 16 are slightly spaced apart. An n-type region 17 is formed in the p-type region 16. Electrodes 18 to 21 are formed in connection with the respective regions 14 to 17. The linear circuit section and $I^2L$ circuit section are isolated from each other by p⁺-type region 22 formed to extend from the surface of the epitaxial layer 5 to the substrate 1.

Fig. 3 shows the equivalent circuit of the npn transistor TR1 constituting the linear circuit shown in Fig. 2. Fig. 4 shows the equivalent circuit of the npn transistor TR2 and npn transistor TR3 constituting the $I^2L$ circuit section shown in Fig. 2. The electrode 18 shown in Fig. 2 is used as a ground terminal in the equivalent circuit of Fig. 4.

Figs. 5 and 6 show models of the respective linear circuit section and $I^2L$ circuit section shown in Fig. 2.

To form a linear transistor having a high breakdown voltage, it is required to set at a sufficiently large value the resistivity $\rho 1$ of an n-type epitaxial layer 23 which corresponds to the epitaxial layers 4 and 5 in Fig. 2, and set at a sufficiently large value the thickness t3 of that portion of the n-type epitaxial layer 23 which intervenes between the buried layer 2 serving as a collector region and the p-type region 6 serving as a base region in Fig. 2. For example, in order to set the breakdown voltage of the epitaxial layer 23 between the regions 2 and 6 to about 30 to 50 V, it is necessary to set the effective thickness t3 of the epitaxial layer 23, to 10 to 20 microns and set the resistivity $\rho 1$ of the epitaxial layer 23 or epitaxial layers 2 and 5 to 1 to 5 $\Omega \cdot cm$.

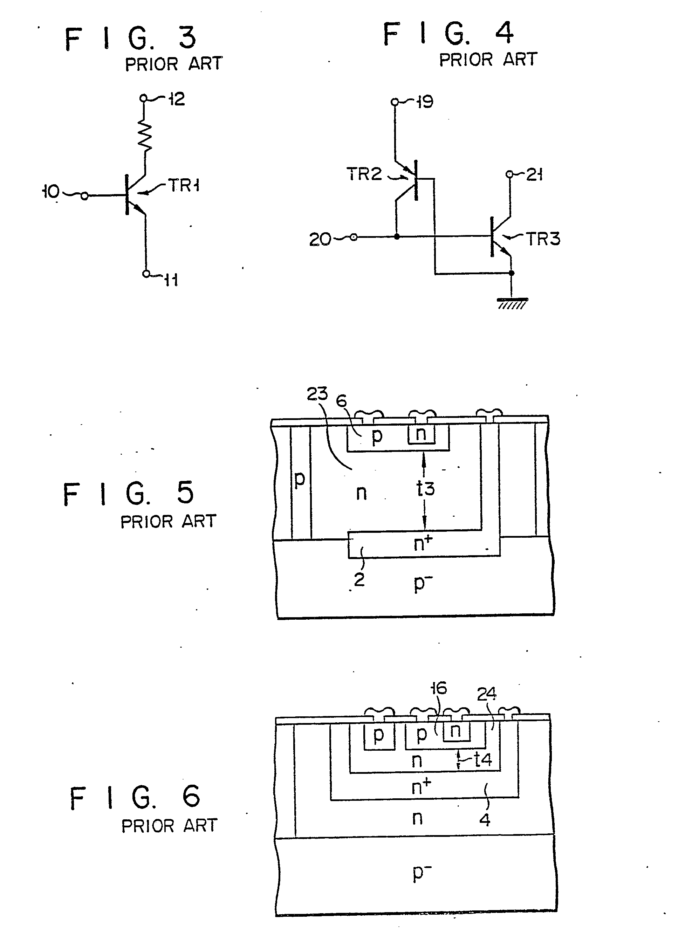

The response characteristic of the $I^2L$ circuit device having the construction as shown in Fig. 6 is represented by a cut-off frequency $f_c$ which is given as follows:

$$f_c = \frac{S1}{S2} \cdot \frac{Dn \cdot N24}{2\pi \, (F+1) \cdot t4 \cdot \int NBdx}$$

where S1 and S2 respectively denote areas of top surface portions of the collector and base of the inverter transistor, F denotes the number of collectors of the inverter transistor, t4 is the thickness of the epitaxial layer 24 between the buried layer 4 and p-type region 16, NB is the impurity concentration of the p-type region 16 serving as the base region, Dn is an electron diffusion coefficient, the N24 is the impurity concentration of the epitaxial layer 24. This equation is explained in "Trans. on Electron devices" (IEEE, March, 1975).

As is evident from the equation, in order to increase the response speed of the $I^2L$ circuit, it is required to increase the impurity concentration N24 of the epitaxial layer 24 and reduce the thickness t4. To meet the requirement, it has hitherto been a practice to form the two epitaxial layers 3 and 5 and form $n^+$-type regions 2 and 4 respectively in the surface regions of the substrate 1 and epitaxial layer 3, as shown in Fig. 1. With this wafer, it is possible to improve the breakdown voltage characteristic of the linear transistor in the semiconductor device of Fig. 2 without substantially affecting the response characteristic of the $I^2L$ circuit section by suitably controlling the thickness and impurity concentration of the epitaxial layer 3 and also possible to improve the response characteristic of the $I^2L$ circuit section without affecting the breakdown voltage characteristic of the linear transistor by suitably controlling the thickness and impurity concentration of the epitaxial layer 5.

However, the semiconductor device shown in Fig. 2 has the following drawbacks.

(1) The n-type epitaxial layers 3 and 5 have to be formed in separate steps, and also the buried layers 2 and 4 have to be formed in separate steps.

(2) If the epitaxial layer 5 is separately formed after the formation of the epitaxial layer 3, the quality of the epitaxial layer 3 is lowered to reduce the yield of the semiconductor wafer.

(3) The formation of the epitaxial layers 3 and 5 requires many manufacture control parameters, and it is difficult to obtain a wafer of stringent ratings.

Owing to these drawbacks, an LSI manufactured using the semiconductor wafer having the two epitaxial layers 3 and 5 and buried layers 2 and 4 formed in different depth positions becomes high in manufacturing cost.

Electronics, Vol. 52, No. 25, 1979 pages 124 to 130, from which a device according to the precharacterizing part of claim 1 is known, and Patents Abstracts of Japan Vol. 2, No. 97, 4716E78 Kobai—No. 53-61981 disclose $I^2L$ semiconductor devices.

An object of the invention is to provide a semiconductor device, which can be obtained using a semiconductor wafer of a simple construction and nevertheless permits to obtain high response characteristic of $I^2L$ circuit section and increase the breakdown voltage of a transistor in a linear circuit section.

According to the present invention, there is provided a semiconductor device comprising a linear circuit section including at least one vertical transistor and an $I^2L$ circuit section including at least one set of injector transistor and inverter transistor which are formed in the same wafer on which said vertical transistor is formed, said wafer including a semiconductor layer of one conductivity type and said injector transistor in said $I^2L$ circuit section being a lateral transistor which includes first and second semiconductor regions of an opposite conductivity type formed on the surface area of said semiconductor layer to face each other, characterised in that said inverter transistor in said $I^2L$ circuit section is a lateral transistor which includes a third semiconductor region of said one conductivity type formed in said second semiconductor region and a fourth semiconductor region of said one conductivity type formed in said semiconductor layer and/or said second semiconductor region to face said third semiconductor region in said second semiconductor region.

Although according to the invention, it is necessary to form a thick semiconductor wafer for increasing the breakdown voltage of the vertical transistor of the linear circuit section, a desired response characteristic of the inverter transistor can be obtained without being influenced by the thickness of the wafer because this transistor is a lateral transistor, thus providing a high speed $I^2L$ circuit section.

This invention can be more fully understood from the following detailed description when taken in conjunction with the accompanying drawings, in which:

Fig. 1 is a sectional diagram showing a prior art semiconductor wafer used to form a linear circuit section and an $I^2L$ circuit section on the same chip;

Fig. 2 is a sectional view of a semiconductor device which is formed using the semiconductor wafer of Fig. 1 and in which the linear circuit section and $I^2L$ circuit section are formed on the same chip;

Figs. 3 and 4 are respectively equivalent circuit diagrams of the linear circuit section and $I^2L$ circuit section of Fig. 2;

Figs. 5 and 6 are views respectively showing models of the linear circuit section and $I^2L$ circuit section shown in Fig. 2;

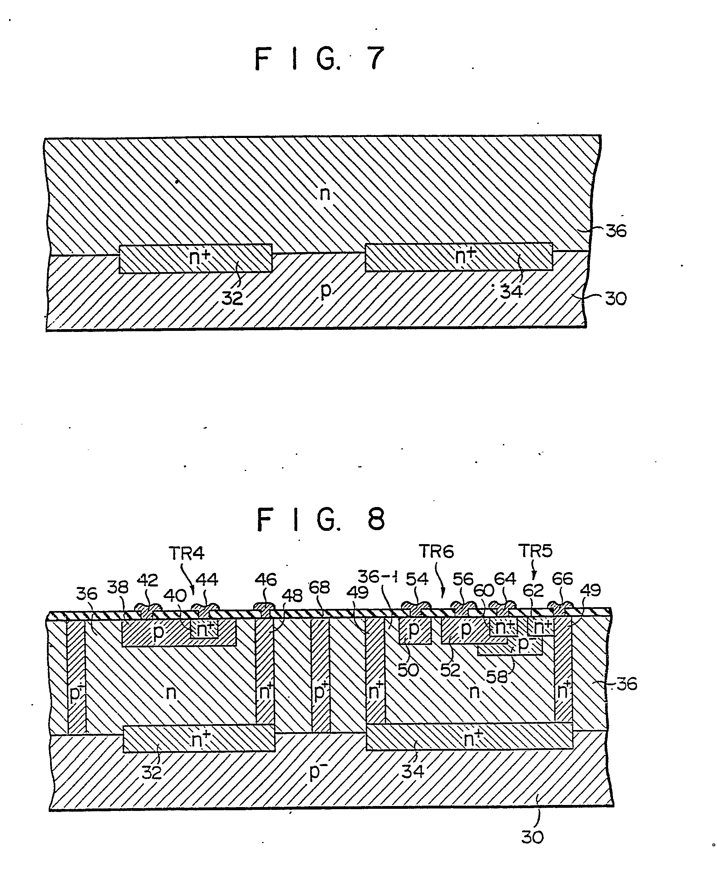

Fig. 7 is a sectional view showing a semiconductor wafer used for manufacturing a semiconductor device according to the invention including a linear circuit section and an $I^2L$ circuit section formed on the same chip;

Fig. 8 is a sectional view showing an embodiment of the semiconductor device according to the invention;

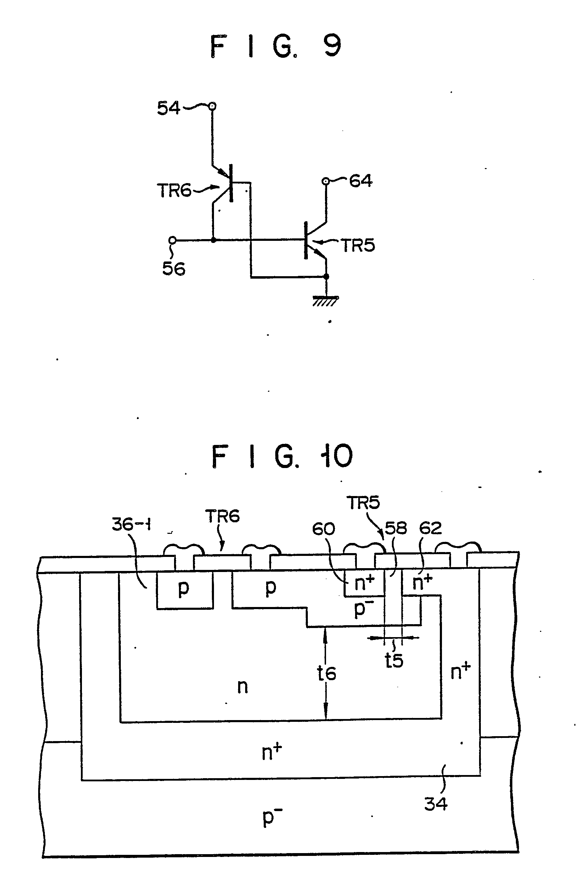

Fig. 9 is a circuit diagram showing the $I^2L$ circuit section of the semiconductor device shown in Fig. 8;

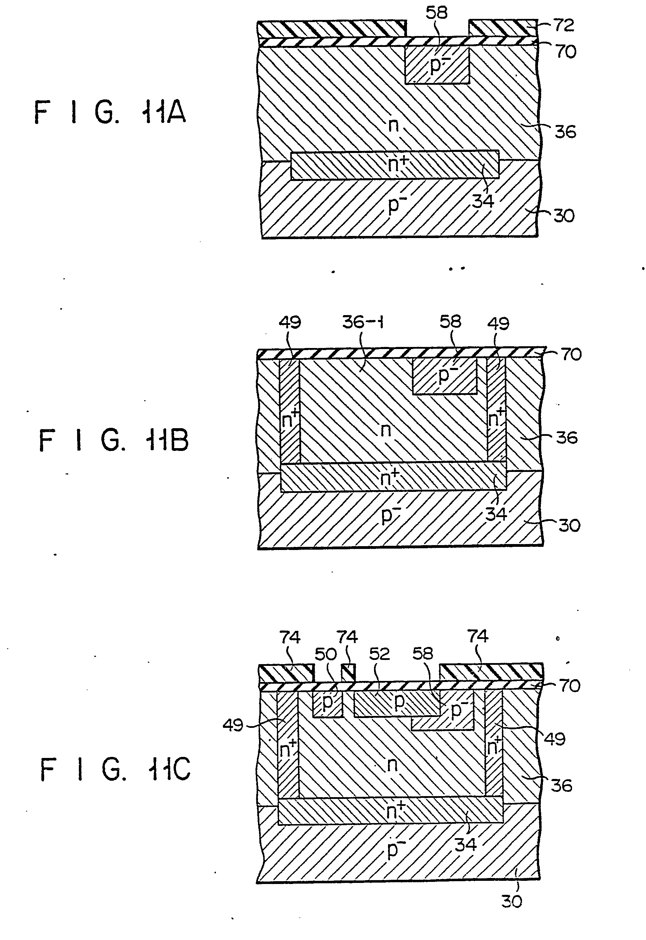

Fig. 10 is a view showing a model of the $I^2L$ circuit section of the semiconductor device shown in Fig. 8;

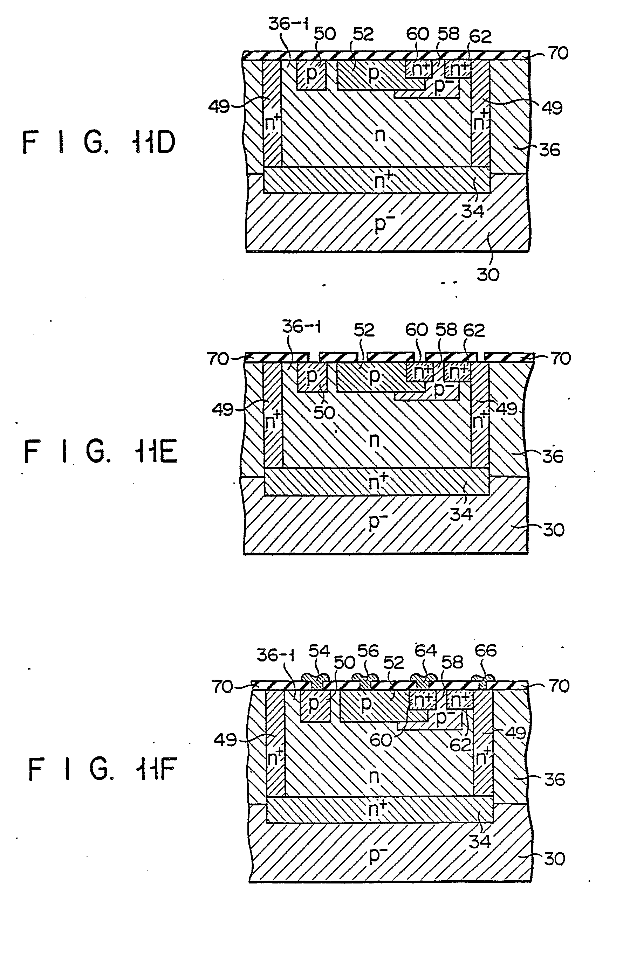

Figs. 11A to 11F are views for illustrating the steps of manufacturing the $I^2L$ circuit section of the semiconductor device shown in Fig. 8; and

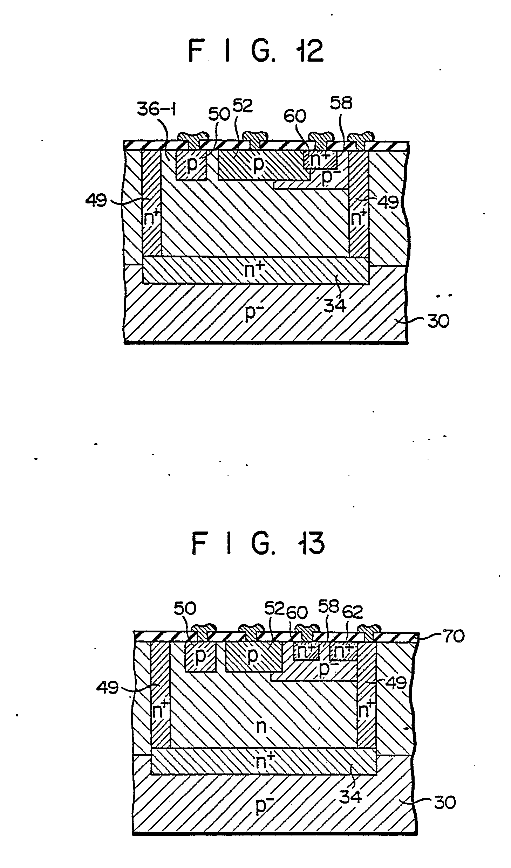

Figs. 12 and 13 are sectional views showing different embodiments of the semiconductor device according to the invention.

Fig. 7 shows a sectional view of the semiconductor wafer used for manufacturing a semiconductor device embodying the invention as shown in Fig. 8 including a linear circuit section of high breakdown voltage and a high speed $I^2L$ circuit section formed in a single semiconductor chip. This semiconductor wafer is obtained by diffusing n-type impurities at a high impurity concentration into mutually spaced-apart surface regions of a $p^-$-type silicon substrate 30 to form $n^+$-type buried layers 32 and 34 and then forming an n-type layer 36 by the epitaxial growth method on the substrate 30 and the buried layers 32 and 34. The $n^+$-type buried layer 32 forms the collector region of transistor TR4 in the linear circuit section shown in Fig. 8. The semiconductor wafer shown in Fig. 7 has been extensively used for manufacturing bipolar semiconductor integrated circuits. Highly advanced and sophisticated techniques are available for manufacturing this semiconductor wafer, and a high quality wafer can be obtained at a low cost. In one embodiment of the invention, the thickness of the epitaxial layer 36 is set to 10 to 20 μ and the resistivity thereof to 1 to 5 $\Omega \cdot cm$ for forming the transistor TR4 of high breakdown voltage in the linear circuit section. According to the invention, the response characteristic of the $I^2L$ circuit section, on the other hand, is hardly influenced by the thickness and impurity concentration of the epitaxial layer 26 as will be discussed hereinafter.

The npn transistor TR4 in the linear circuit section of the semiconductor device shown in Fig. 8 has the same construction as the npn transistor TR1 in the linear circuit section of the semiconductor device shown in Fig. 2. More particularly, the base region of the transistor TR4 is constituted by a p-type region 38 formed in the surface region of the epitaxial layer 36, and the emitter region is constituted by an $n^+$-type region 40 formed in the p-type region 38. Base and emitter electrodes 42 and 44 are coupled to the respective p- and $n^+$-type regions 38 and 40. A collector electrode 46 is coupled to the $n^+$-type region 32 via $n^+$-type region 48 which extends from the surface of the epitaxial layer 36 to the n-type region 32.

The $I^2L$ circuit section is formed in that portion 36-1 of the epitaxial layer 36 which is surrounded by an $n^+$-type region 49 formed to extend from the surface of the epitaxial layer 36 to the $n^+$-type layer 34. An injector transistor TR6 in the $I^2L$ circuit section is formed of p-type regions 50 and 52 formed in mutually spaced-apart manner in the surface region of the epitaxial layer 36. More particularly, the emitter and collector of the injector transistor TR6 are constituted by the respective p-type regions 50 and 52, and the active base is constituted by part of the epitaxial layer 36 intervening between the p-type regions 50 and 52. Electrodes 54 and 56 are formed in connection with the respective p-type regions. A lateral inverter transistor TR5 is constituted by $p^-$-type region 58 form to partly overlap the p-type region 52 in the surface region of epitaxial layer 36-1, $n^+$-type region 60 formed in part of the regions 52 and 58 and $n^+$-type region 62 formed in contact with the $n^+$-type region 49 and having a portion which extends into the $p^-$-type region 58 to face the $n^+$-type region with a small distance. More particularly, the emitter of the inverter transistor TR5 is constituted by the $n^+$-type region 62, the collector is constituted by the $n^+$-type region 60, and the base is constituted by part of the $p^-$-type region 58 intervening between the $n^+$-type regions 60 and 62. Electrodes 64 and 66 are formed in connection with the respective $n^+$-type regions 60 and 62. The linear circuit section and $I^2L$ circuit section are isolated from each other by $p^+$-type region 68 formed to extend from the surface of the epitaxial layer 36 to the substrate 30.

Figs. 9 and 10 show the equivalent circuit and a model of the $I^2L$ section shown in Fig. 8, respectively. The electron injection efficiency of the lateral transistor TR5 is greatly influenced by the ratio of impurity concentrations in the emitter region 62 and base region 58. In this embodiment, a sufficiently high electron injection efficiency can be obtained because it is possible to set a high impurity concentration for the emitter region 62 and a low impurity concentration for the base region 56. In addition, it is possible to further increase the current amplification factor of the inverter transistor TR5 because the regions 60 and 62 can be formed such that the effective width t5 of the base region 58, i.e., the gap between the collector 60 and emitter 62, is sufficiently small. Further, the emitter resistance may be made low by virtue of the high impurity concentration of the emitter region 62. Thus, the inverter transistor TR5 is a lateral transistor, its response characteristic can be set without being substantially influenced by the gap t6 between the base region 34 and buried layer 34 and the impurity concentration of the epitaxial layer 36-1. While a high breakdown voltage of the linear circuit section transistor TR4 requires a large thickness and a low impurity concentration of the epitaxial layer 36, the reduction of the impurity concentration of the epitaxial layer 36 increases the electron injection efficiency of the inverter transistor TR5 and improves the response characteristic of the $I^2L$ circuit section.

In general, it is understood to cause a large current through the inverter transistor TR5, which is a lateral transistor and carries main current in the lateral direction. According to the invention, however, it is possible to obtain a desired circuit characteristic with the transistor of the above construction because the $I^2L$ circuit section can be driven with a small current of the order of 10 to several 100 μA.

Figs. 11A to 11F are views showing the steps involved in the formation of the $I^2L$ circuit section shown in Fig. 8. As shown in Fig. 11A, insulating film 70 is formed to cover the semiconductor wafer, and photoresist film 72 having a desired pattern is formed on the insulating layer 70. Boron is then selectively injected as a p-type impurity by the ion implantation method into the epitaxial layer 36 with the photoresist layer 72 as a mask to form the $P^-$-type region 58 in the epitaxial layer 36. At this time, the injection rate of the p-type inpurity boron is controlled such that the $p^-$-type region 58 may have a very low impurity concentration. Subsequently, the photoresist film 72 is removed, and the insulating film 70 is partly removed. Then, an n-type impurity is diffused into the epitaxial layer 36 to form the' n+-type region 49 extending from the surface of the epitaxial layer 36 to the n+-type region 34, followed by covering the exposed surface of the epitaxial layer 36 with the insulating layer 70 as shown in Fig. 11B. This n+-type region 49 cooperates with the n+-type region 34 to isolate the n-type epitaxial layer portion 36-1 from the rest of the epitaxial layer 36. This region 49 is also used as part of the emitter of the inverter transistor TR5.

A photoresist film 74 having a predetermined pattern is then formed on the insulating layer 79 as shown in Fig. 11C. Impurities of p-type are subsequently injected by the ion implantation method into the epitaxial layer 36-1 with the photoresist film 74 as a mask to form the p-type regions 50 and 52. The p-type region 52 is formed such that it is electrically connected to the p⁻-type region 58.

The photoresist 74 is then removed, and a plurality of openings are formed in selected portions of the insulating layer 70. Subsequently, impurities of n-type are diffused through these openings to form the n+-type regions 60 and 62 closely spaced apart, for instance by a distance of about 100 nm (1000 Å) as shown in Fig. 11D. At this time, it is important that the facing portions of the n+-type regions 60 and 62 are both formed in the p⁻-type region 58. With this construction, electrons are injected at a high electron injection efficiency from the n+-type region 62 into the p⁻-type region 58.

Afterwards, electrode holes for forming the electrodes for the regions 50, 52, 60 and 62 are formed, as shown in Fig. 11E. The electrodes 54, 56, 64 and 66 are then formed in connection with the respective regions 50, 52, 60 and 62.

When manufacturing the semiconductor device as shown in Fig. 8, it is possible to form the n+-type region 48 in the same step as the n+-type region 49, to form the p-type region 38 in the same step as the regions 50 and 52 and to form the n+-type region 40 in the same step as the n+-type regions 60 and 62.

While a preferred embodiment of the invention has been described, this invention is not limited thereto. For example, while in the above embodiment, the p⁻-type region 58 has been spaced apart from the n+-type region, the region 58 may be formed in contact with the region 49 as shown in Fig. 12. In this case, the n+-type region 49 serves as the emitter region of the transistor TR5, and the formation of the n+-type region 62 need not be formed in the step shown in Fig. 11D.

Further the region 60 may be formed solely in the regions 58 as shown in Fig. 13.

Further, it is possible to reverse the conductivity of the semiconductor layers and regions used in the above embodiment.

## Claims

1. A semiconductor device comprising a linear circuit section including at least one vertical transistor (TR4) and an I²L circuit section including at least one set of injector transistor (TR6) and inverter transistor (TR5) which are formed in the same wafer on which said vertical transistor (TR4) is formed, said wafer including a semiconductor layer (36) of one conductivity type and said injector transistor (TR6) in said I²L circuit section being a lateral transistor which includes first and second semiconductor regions (50, 52, 58) of an opposite conductivity type formed on the surface area of said semiconductor layer (36) to face each other, characterised in that said inverter transistor (TR5) in said I²L circuit section is a lateral transistor which includes a third semiconductor region (60) of said one conductivity type formed in said second semiconductor region (52, 58) and a fourth semiconductor region (62) of said one conductivity type formed in said semiconductor layer (36) and/or said second semiconductor region (52, 58) to face said third semiconductor region (60) in said second semiconductor region (52, 58).

2. A semiconductor device according to claim 1, wherein the vertical transistor in said linear circuit includes:
   a fifth semiconductor region (38) of said opposite conductivity type formed in a surface region of said semiconductor layer (36) and constituting a base region; and
   a sixth semiconductor region (40) of the said one conductivity type formed in said fifth semiconductor region and constituting an emitter region.

3. A semiconductor device according to claim 1 or 2, characterised in that said wafer further includes a semiconductor substrate (30) of said opposite conductivity type and seventh and eighth semiconductor regions (32, 34) of said one conductivity type formed in the surface area of said semiconductor substrate (30), said semiconductor layer (36) being formed on said semiconductor substrate (30) and on said seventh and eight semiconductor regions (32, 34) and having a lower impurity concentration than said seventh and eighth semiconductor regions (32, 34).

4. A semiconductor device according to claim 3, wherein said second semiconductor region (52, 58) has an impurity concentration lower in its portion invervening between said third and fourth semiconductor regions (60, 62) than in its portion facing said first semiconductor region (50).

5. A semiconductor device according to claim 3 or 4, wherein said fourth semiconductor region includes a first portion facing said third semiconductor region (60) and a second portion (49) electrically coupled to said eighth semiconductor region (34) and extending from the surface of said semiconductor layer (36) to said eighth semiconductor region (34) to co-operate with said eighth semiconductor region (34) to surround said first to third semiconductor regions.

6. A semiconductor device according to claim 3 or 4, wherein said fourth semiconductor region (49) extends from the surface of said semiconductor layer (36) to said eighth semiconductor region (34) and surrounds said first to third semiconductor regions.

## Patentansprüche

1. Halbleitervorrichtung, umfassend einen linearen Leitungsabschnitt, enthaltend mindestens einen vertikalen Transistor (TR4) und einen I²L-Schaltungsabschnitt mit mindestens einem Satz eines Injektor-Transistors (TR6) und eines Inverter-Transistors (TR5), die im gleichen Wafer ausgebildet sind, auf dem der vertikale Transistor (TR4) gebildet ist, wobei der Wafer Halbleiterschicht (36) eines Leitfähigkeitstyps einschließt und wobei der Injektor-Transistor (TR6) im I²L-Schaltungsabschnitt ein Lateral-Transistor ist, der erste und zweite Halbleiterregionen (50, 52, 58) eines entgegengesetzten Leitfähigkeitstyps umfaßt, ausgebildet auf dem Oberflächenfled der Halbleiterschicht (36), und zwar einander gegenüberliegend, dadurch gekennzeichnet, daß der Inverter-Transistor (TR5) in dem I²L-Schaltungsabschnitt ein Lateral-Transistor ist, der eine dritte Halbleiterregion (60) des einen Leitfähigkeitstyps umfaßt, ausgebildet in der zweiten Halbleiterregion (52, 58) sowie eine vierte Halbleiterregion (62) des einen Leitfähigkeitstyps, ausgebildet in der Halbleiterschicht (36) und/oder der zweiten Halbleiterregion (52, 58), um der dritten Halbleiterregion (60) in der zweiten Halbleiterregion (52, 58) gegenüber zu liegen.

2. Halbleitervorrichtung nach Anspruch 1, dadurch gekennzeichnet, daß der vertikale Transistor in der linearen Schaltung umfaßt:

eine fünfte Halbleiterregion (38) des entgegengesetzten Leitfähigkeitstyps, gebildet in einer Oberflächenregion der Halbleiterschicht (36) und eine Basisregion bildend, und

eine sechste Halbleiterregion (40) des einen Leitfähigkeitstyps, gebildet in der fünften Halbleiterregion und eine Emitterregion bildend.

3. Halbleitervorrichtung nach Anspruch 1 oder 2, dadurch gekennzeichnet, daß der Wafer außerdem ein Halbleitersubstrat (30) des entgegengesetzten Leitfähigkeitstyps und siebente und achte Halbleiterregionen (32, 34) des einen Leitfähigkeitstyps aufweist, gebildet in dem Oberflächengebiet des Halbleitersubstrats (30), wobei die Halbleiterschicht (36) auf dem Halbleitersubstrat (30) und auf den siebenten und achten Halbleiterregionen (32, 34) ausgebildet ist und eine geringere Störstellenkonzentration aufweist als die siebenten und achten Halbleiterregionen (32, 34).

4. Halbleitervorrichtung nach Anspruch 3, dadurch gekennzeichnet, daß die zweite Halbleiterregion (52, 58) eine Störstellenkonzentration aufweist, die in ihrem zwischen den dritten und vierten Halbleiterregionen (60, 62) leigenden Bereich geringer ist als in ihrem Bereich, der der ersten Halbleiterregion (50) gegenüberliegt.

5. Halbleitervorrichtung nach Anspruch 3 oder 4, dadurch gekennzeichnet, daß die vierte Halbleiterregion einen ersten Bereich umfaßt, der dem dritten Halbleiterbereich (60) gegenüberliegt, und einen zweiten Bereich (49), welcher elektrisch mit der achten Halbleiterregion (34) gekoppelt ist und von der Oberfläche der Halbleiterschicht (36) sich zur achten Halbleiterregion (34) erstreckt, um mit. der achten Halbleiterregion (34) zusammenzuwirken, um die erste und dritte Halbleiterregion zu umgeben.

6. Halbleitervorrichtung nach Anspruch 3 oder 4, dadurch gekennzeichnet, daß die vierte Halbleiterregion (39) sich von der Oberfläche der Halbleiterschicht (36) bis zur achten Halbleiterregion (34) erstreckt und die erste und dritte Halbleiterregion umgibt.

## Revendications

1 Dispositif à semiconducteur comprenant une section de circuit linéaire incluant au moins un transistor vertical (TR4) et une section de circuit à logique à injection intégrée (I²L) incluant au moins un groupe d'un transistor injecteur (TR6) et d'un transistor inverseur (TR5) qui sont formés dans la même tranche que sur laquelle est formé le transistor vertical (TR4), la tranche incluant une couche semiconductrice (36) d'un type de conductivité et le transistor injecteur (TR6) de la section de circuit I²L étant un transistor latéral qui inclut des première et deuxième régions semiconductrices (50, 52, 58) d'un type inverse de conductivité formées sur la zone de surface de la couche semiconductrice (36) pour qu'elles se fassent face, caractérisé en ce que le transistor inverseur (TR5) de la section de circuit I²L est un transistor latéral qui comprend une troisième région semiconductrice (60) dudit type de conductivité formée dans la deuxième région semiconductrice (52, 58) et une quatrième région semiconductrice (62) dudit type de conductivité formée dans la couche semiconductrice (36) et/ou dans la deuxième région semiconductrice (52, 58) pour qu'elle soit en face de la troisième région semiconductrice (60) dans la deuxième région semiconductrice (52, 58).

2. Dispositif à semiconducteur selon la revendication 1, caractérisé en ce que le transistor vertical inclus dans le circuit linéaire comprend:

une cinquième région semiconductrice (38) dudit type inverse de conductivité formé dans une région de surface de la couche semiconductrice (36) et constituant une région de base; et

une sixième région semiconductrice (40) dudit type de conductivité formée dans la cinquième région semiconductrice et constituant une région d'émetteur.

3. Dispositif à semiconducteur selon l'une quelconque des revendications 1 et 2, caractérisé en ce que la tranche comprend en outre un substrat semiconducteur (30) dudit type inverse de conductivite et des septième et huitième régions semiconductrices (32, 34) dudit type de conductivité formées dans la zone de surface du substrat semiconducteur (30), la couche semiconductrice (36) étant formée sur le substrat semiconducteur (30) et sur les septième et huitième régions semiconductrices (32, 34) et ayant une concentration d'impuretés inférieure à celle des septième et huitième régions semiconductrices (32, 34).

4. Dispositif à semiconducteur selon la revendication 3, caractérisé en ce que la deuxième région semiconductrice (52, 58) a une concentration d'impuretés inférieure dans sa partie interposée entre les troisième et quatrième régions semiconductrices (60, 62) à celle dans sa partie en face de la première région semiconductrice (50).

5. Dispositif à semiconducteur selon l'une quelconque des revendications 3 et 4, caractérisé en ce que la quatrième région semiconductrice comprend une première partie en face de la troisième région semiconductrice (60) et une deuxième partie (49) reliée électriquement à la huitième région semiconductrice (34) et s'étendant de la surface de la couche semiconductrice (36) à la huitième région semiconductrice (34) pour coopérer avec la huitième région semiconductrice (34) afin d'entourer la première à la troisième régions semiconductrices.

6. Dispositif à semiconducteur selon l'une quelconque des revendications 3 et 4, caractérisé en ce que la quatrième région semiconductrice (49) s'étend de la surface de la couche semiconductrice (36) à la huitième région semiconductrice (34) et entoure la première à la troisième régions semiconductrices.

# F I G. 1
### PRIOR ART

# F I G. 2
### PRIOR ART

# F I G. 3
## PRIOR ART

12

TR1

10

11

# F I G. 4
## PRIOR ART

19

TR2

21

20

TR3

# F I G. 5
## PRIOR ART

23  6

p  n

p

n

t3

n⁺

2

p⁻

# F I G. 6
## PRIOR ART

16  24

p  p  n

n

t4

n⁺

n  4

p⁻

# F I G. 7

# F I G. 8

# F I G. 9

# F I G. 10

F I G. 11A

F I G. 11B

F I G. 11C

F I G. 11D

F I G. 11E

F I G. 11F

F I G. 12

F I G. 13